# EUROPEAN PATENT APPLICATION

(11) **EP 4 350 030 A1**
(43) Date of publication of application: **10.04.2024**
(21) Application number: 23199139.9
(22) Date of filing: 22.09.2023
(51) Int. Cl.: C23C 16/02, C23C 16/14, C23C 16/455, C23C 16/56, H01L 21/02

(54) **METHOD OF PROCESSING SUBSTRATE, METHOD OF MANUFACTURING SEMICONDUCTOR DEVICE, SUBSTRATE PROCESSING APPARATUS, AND PROGRAM**

(30) Priority: 26.09.2022 JP 2022152830
(71) Applicant: Kokusai Electric Corporation, Tokyo 101-0045 (JP)
(72) Inventor: KURIBAYASHI, Koei, Toyama 939-2393 (JP); YAMAMOTO, Kaoru, Toyama 939-2393 (JP)
(74) Representative: Bardehle Pagenberg Partnerschaft mbB Patentanwälte Rechtsanwälte

(57) **Abstract**

There is provided a technique that includes: (a) loading a substrate into a process container at a loading temperature; (b) setting an interior of the process container to a film formation temperature; (c) forming a metal film on a surface of the substrate by supplying a process gas into the process container; (d) setting the interior of the process container to an unloading temperature lower than the loading temperature; and (e) unloading the substrate from the process container.

## Description

### CROSS-REFERENCE TO RELATED APPLICATION

This application is based upon and claims the benefit of priority from Japanese Patent Application No. 2022-152830, filed on September 26, 2022, the entire contents of which are incorporated herein by reference.

### TECHNICAL FIELD

The present disclosure relates to an effective technique applied to a method of processing a substrate, a method of manufacturing a semiconductor device, a substrate processing apparatus, and a program.

### BACKGROUND

In the related art, a metal film is used as a word line of a NAND flash memory with a three-dimensional structure. Further, as the metal film, for example, a Mo-containing film containing molybdenum (Mo) is often used.

However, when the metal film is formed on a substrate, an electrical resistance (or resistivity) of the metal film may increase depending on a temperature at which the substrate is unloaded from a process chamber.

### SUMMARY

Some embodiments of the present disclosure provide a technique capable of improving electrical characteristics of a metal film.

According to some embodiments of the present disclosure, there is provided a technique that includes: (a) loading a substrate into a process container at a loading temperature; (b) setting an interior of the process container to a film formation temperature; (c) forming a metal film on a surface of the substrate by supplying a process gas into the process container; (d) setting the interior of the process container to an unloading temperature lower than the loading temperature; and (e) unloading the substrate from the process container

### BRIEF DESCRIPTION OF DRAWINGS

The accompanying drawings, which are incorporated in and constitute a part of the specification, illustrate embodiments of the present disclosure.
FIG. 1 is a longitudinal and cross-sectional view schematically showing a substrate processing apparatus according to embodiments of the present disclosure.
FIG. 2 is a schematic configuration diagram of a controller of a substrate processing apparatus according to the embodiments of the present disclosure, in which a control system of the controller is shown in a block diagram.
FIG. 3 is a flow diagram for explaining a method of manufacturing a semiconductor device according to a first example of a process of a method of processing a substrate of the present disclosure.
FIG. 4 is a flow diagram for explaining a method for manufacturing a semiconductor device according to a second example of the process of the method of processing the substrate of the present disclosure.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

Hereinafter, embodiments of the present disclosure will be described with reference to the accompanying drawings. However, in the following description, the same components may be denoted by the same reference numerals, and duplicate explanation thereof may not be repeated. To make the description clearer, the drawings may be schematically represented compared to the actual aspects, but the drawings are examples and do not limit interpretation of the present disclosure. The drawings used in the following description are schematic, and dimensional relationships, ratios, and the like of various components shown in the drawings may not match actual ones. Further, dimensional relationships, ratios, and the like of various components among plural drawings may not always match each other.

### (1) Configuration of Substrate Processing Apparatus

A substrate processing apparatus 10 includes a process furnace 202 in which a heater 207 as a heating means or unit (a heating equipment or a heating system) is provided. The heater 207 is formed in a cylindrical shape and is supported by a heater base (not shown) as a holding plate so as to be vertically installed.

An outer tube 203 constituting a reaction container (a process container) is disposed inside the heater 207 so as to be concentric with the heater 207. The outer tube 203 is made of, for example, a heat resistant material such as quartz (SiO₂) or silicon carbide (SiC) and is formed in a cylindrical shape with its upper end closed and its lower end opened. A manifold (inlet flange) 209 is disposed below the outer tube 203 so as to be concentric with the outer tube 203. The manifold 209 is made of, for example, a metal material such as stainless steel (SUS) and is formed in a cylindrical shape with its upper and lower ends opened. An O-ring 220a serving as a seal is installed between an upper end side of the manifold 209 and the outer tube 203. When the manifold 209 is supported by the heater base, the outer tube 203 is installed vertically.

An inner tube 204 constituting the process container is disposed inside the outer tube 203. The inner tube 204 is made of, for example, a heat resistant material such as quartz (SiO₂) or silicon carbide (SiC) and is formed in a cylindrical shape with its upper end closed and its lower end opened. The process container mainly includes the outer tube 203, the inner tube 204, and the manifold 209. A process chamber 201 is formed in a hollow cylindrical area (inside the inner tube 204) of the process container.

The process chamber 201 is configured to be capable of accommodating wafers 200 as substrates in such a state that the wafers 200 are arranged in a horizontal posture and in multiple stages along a vertical direction by a boat 217, which is described below.

Nozzles 410 and 420 are installed in the process chamber 201 so as to penetrate a sidewall of the manifold 209 and the inner tube 204. Gas supply pipes 310 and 320 are connected to the nozzles 410 and 420, respectively. However, the process furnace 202 in the embodiments of the present disclosure is not limited to the above-described shape.

Mass flow controllers (MFCs) 312 and 322, which are flow rate controllers (flow rate control parts), are installed at the gas supply pipes 310 and 320, respectively, sequentially from the upstream side. Further, valves 314 and 324, which are opening/closing valves, are installed at the gas supply pipes 310 and 320, respectively. Gas supply pipes 510 and 520 configured to supply an inert gas are connected to the gas supply pipes 310 and 320 at the downstream side of the valves 314 and 324, respectively. MFCs 512 and 522, which are flow rate controllers (flow rate control parts), and valves 514 and 524, which are opening/closing valves, are installed at the gas supply pipes 510 and 520, respectively, sequentially from the upstream side.

The nozzles 410 and 420 are connected to leading ends of the gas supply pipes 310 and 320, respectively. The nozzles 410 and 420 are constituted as L-shaped nozzles, and their horizontal sides are formed so as to penetrate the sidewall of the manifold 209 and the inner tube 204. Vertical sides of the nozzles 410 and 420 are formed inside a channel-shaped (groove-shaped) preliminary chamber 201a formed so as to protrude outward in a radial direction of the inner tube 204 and extend in the vertical direction thereof, and are also formed in the preliminary chamber 201a toward the upper side (upper side in the arrangement direction of the wafers 200) along the inner wall of the inner tube 204.

The nozzles 410 and 420 are installed so as to extend from a lower region to an upper region of the process chamber 201, and a plurality of gas supply holes 410a and 420a are formed at positions facing the wafers 200, respectively. Thus, a process gas is supplied from the gas supply holes 410a and 420a of the nozzles 410 and 420 to the wafers 200 respectively. The plurality of gas supply holes 410a and 420a are formed from a lower side to an upper side of the inner tube 204 and formed with the same aperture area at the same aperture pitch. However, the gas supply holes 410a and 420a are not limited to the above-described shape. For example, the aperture area may be gradually increased from the lower side to the upper side of the inner tube 204. This makes it possible to make a flow rate of the gas supplied from the gas supply holes 410a and 420a more uniform.

The plurality of gas supply holes 410a and 420a of the nozzles 410 and 420 are formed at height positions from a lower side to an upper side of the boat 217, which is described below. Therefore, the process gas supplied into the process chamber 201 from the gas supply holes 410a and 420a of the nozzles 410 and 420 is supplied to the entire region of the wafers 200 accommodated from the lower side to the upper side of the boat 217. The nozzles 410 and 420 may be installed to extend from the lower region to the upper region of the process chamber 201, but may be installed to extend to the vicinity of a ceiling of the boat 217.

As a process gas, a precursor gas is supplied from the gas supply pipe 310 into the process chamber 201 via the MFC 312, the valve 314, and the nozzle 410.

As a process gas, a reducing gas is supplied from the gas supply pipe 320 into the process chamber 201 via the MFC 322, the valve 324, and the nozzle 420.

An inert gas is supplied from the gas supply pipes 510 and 520 into the process chamber 201 via the MFCs 512 and 522, the valves 514 and 524, and the nozzles 410 and 420, respectively. Further, the inert gas may be a carrier gas.

A process gas supply system 300 mainly includes the gas supply pipes 310 and 320, the MFCs 312 and 322, and the valves 314 and 324. Further, the process gas supply system may include the nozzles 410 and 420. The process gas supply system may be simply referred to as a gas supply system. When a Mo-containing gas flows from the gas supply pipe 310, a Mo-containing gas supply system mainly includes the gas supply pipe 310, the MFC 312, and the valve 314. Further, the Mo-containing gas supply system may include the nozzle 410. Further, when a reducing gas flows from the gas supply pipe 320, a reducing gas supply system mainly includes the gas supply pipe 320, the MFC 322, and the valve 324. Further, the reducing gas supply system may include the nozzle 420. Further, an inert gas supply system mainly includes the gas supply pipes 510 and 520, the MFCs 512 and 522, and the valves 514 and 524.

A high-thermal conductive gas is supplied from a gas supply pipe 330 into the process chamber 201 via a MFC 332, a valve 334, and the nozzle 420. The high-thermal conductive gas supply system mainly includes the gas supply pipe 330, the MFC 332, and the valve 334. Further, the high-thermal conductive gas supply system may include the nozzle 420. Further, the process gas supply system 300 may include the gas supply pipe 330, the MFC 332, and the valve 334.

Further, when a reductive high-thermal conductive gas is supplied as a reducing gas from the gas supply pipe 320, the gas supply pipe 330, the MFC 332, and the valve 334 may be omitted. In such a case, a reducing gas supply system, a high-thermal conductive gas supply system, or a reductive high-thermal conductive gas supply system may mainly include the gas supply pipe 320, the MFC 322, and the valve 324. Further, the reducing gas supply system, the high-thermal conductive gas supply system, or the reductive high-thermal conductive gas supply system may include the nozzle 420. By using the reductive high-thermal conductive gas, the supply system may be simplified as compared with a case where the reducing gas and the high-thermal conductive gas are separately supplied.

A method of supplying a gas in the embodiments of the present disclosure is to transfer a gas via the nozzles 410 and 420 arranged in the preliminary chamber 201a in an annular vertically long space defined by the inner wall of the inner tube 204 and the ends of a plurality of wafers 200. Then, the gas is ejected into the inner tube 204 from the plurality of gas supply holes 410a and 420a formed at positions of the nozzles 410 and 420, which face the wafers. More specifically, the process gas or the like is ejected toward a direction parallel to the surfaces of the wafers 200 by the gas supply hole 410a of the nozzle 410 and the gas supply hole 420a of the nozzle 420.

An exhaust hole (exhaust port) 204a is a through-hole formed in a sidewall of the inner tube 204 at a position facing the nozzles 410 and 420. For example, the exhaust hole 204a is a slit-shaped through-hole formed elongated in the vertical direction. A gas supplied into the process chamber 201 from the gas supply holes 410a and 420a of the nozzles 410 and 420 and flowing on the surfaces of the wafers 200 passes through the exhaust hole 204a and flows into an exhaust passage 206 constituted by a gap formed between the inner tube 204 and the outer tube 203. Then, the gas flowing through the exhaust passage 206 flows into an exhaust pipe 231 and is discharged to the outside of the process furnace 202.

The exhaust hole 204a is formed at a position facing the plurality of wafers 200, and a gas supplied from the gas supply holes 410a and 420a to the vicinity of the wafers 200 in the process chamber 201 flows in the horizontal direction and then flows into the exhaust passage 206 via the exhaust hole 204a. The exhaust hole 204a is not limited to the slit-shaped through-hole, but may be constituted by a plurality of holes.

The exhaust pipe 231 configured to exhaust an internal atmosphere of the process chamber 201 is installed at the manifold 209. A pressure sensor 245 as a pressure detector (pressure detection part) configured to detect an internal pressure of the process chamber 201, an auto pressure controller (APC) valve 243, and a vacuum pump 246 as a vacuum-exhauster are connected to the exhaust pipe 231, sequentially from the upstream side. The APC valve 243 may perform or stop a vacuum-exhausting operation in the process chamber 201 by opening or closing the valve while the vacuum pump 246 is actuated, and may also regulate the internal pressure of the process chamber 201 by adjusting an opening state of the valve while the vacuum pump 246 is actuated. An exhaust system mainly includes the exhaust hole 204a, the exhaust passage 206, the exhaust pipe 231, the APC valve 243, and the pressure sensor 245. The exhaust system may include the vacuum pump 246.

A seal cap 219 serving as a furnace opening lid configured to be capable of hermetically sealing a lower end opening of the manifold 209 is installed under the manifold 209. The seal cap 219 is configured to come into contact with the lower end of the manifold 209 from the lower side in the vertical direction. The seal cap 219 is made of, for example, metal such as stainless steel (SUS), and is formed in a disc shape. An O-ring 220b as a seal making contact with the lower end of the manifold 209 is installed on an upper surface of the seal cap 219. A rotator 267 configured to rotate the boat 217 in which the wafers 200 are accommodated is installed on the opposite side of the process chamber 201 with respect to the seal cap 219. A rotary shaft 255 of the rotator 267 penetrates the seal cap 219 and is connected to the boat 217. The rotator 267 is configured to rotate the wafers 200 by rotating the boat 217. The seal cap 219 is configured to be vertically moved up or down by a boat elevator 115 as a loading/unloading equipment (elevator) vertically installed outside the outer tube 203. The boat elevator 115 is configured to be capable of loading or unloading the boat 217 into or from the process chamber 201 by moving the seal cap 219 up or down. The boat elevator 115 is configured as a transfer apparatus (transfer system) configured to transfer the boat 217 and the wafers 200 accommodated in the boat 217 into or out of the process chamber 201.

The boat 217 serving as a substrate support is configured to support a plurality of wafers 200, for example, 25 to 200 sheets of wafers 200, in such a state that the wafers 200 are arranged in a horizontal posture along a vertical direction with centers of the wafers 200 aligned with one another. That is, the boat 217 is configured to arrange the wafers 200 to be spaced apart from each other. The boat 217 is made of, for example, a heat resistant material such as quartz or SiC. Heat insulating plates 218 made of, for example, a heat resistant material such as quartz or SiC, are installed in a horizontal posture and in multiple stages (not shown) below the boat 217. This configuration makes it difficult to transfer heat from the heater 207 toward the seal cap 219. However, the embodiments of the present disclosure is not limited to the above-described form. For example, instead of installing the heat insulating plates 218, a heat insulating cylinder made of a heat resistant material such as quartz or SiC may be installed below the boat 217.

In the present disclosure, the expression of a numerical range such as "25 to 200 sheets" means that a lower limit and an upper limit thereof are included in the range. Therefore, for example, "25 to 200 sheets" means "25 sheets or more and 200 sheets or less." The same also applies to other numerical ranges.

A temperature sensor 263 serving as a temperature detector is installed in the inner tube 204. Based on temperature information detected by the temperature sensor 263, a state of supplying electric power to the heater 207 is regulated such that a temperature distribution inside the process chamber 201 becomes a desired temperature distribution. The temperature sensor 263 is formed in an L-shape, like the nozzles 410 and 420, and is installed along the inner wall of the inner tube 204.

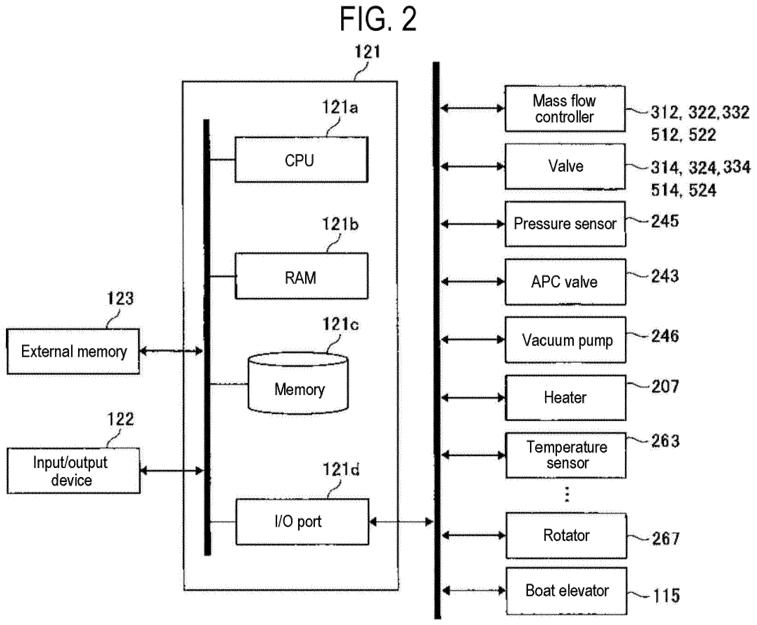

As shown in FIG. 2, a controller 121, which is a control part (control means or unit), is constituted as a computer including a central processing unit (CPU) 121a, a random access memory (RAM) 121b, a memory 121c, and an I/O port 121d. The RAM 121b, the memory 121c, and the I/O port 121d are configured to be capable of exchanging data with the CPU 121a via an internal bus. An input/output device 122 formed of, e.g., a touch panel or the like, is connected to the controller 121.

The memory 121c is constituted by, for example, a flash memory, a hard disk drive (HDD), or the like. A control program that controls operations of a substrate processing apparatus and a process recipe in which sequences and conditions of a method of manufacturing a semiconductor device described below are written, and the like are readably stored in the memory 121c. The process recipe functions as a program that is combined to cause the controller 121 to execute each process (each step) in the method of manufacturing a semiconductor device described below, to obtain a predetermined result. Hereinafter, the process recipe and the control program may be generally and simply referred to as a "program." When the term "program" is used herein, it may indicate a case of including the process recipe, a case of including the control program, or a case of including a combination of the process recipe and the control program. The RAM 121b is constituted as a memory area (work area) in which a program or data read by the CPU 121a is temporarily stored.

The I/O port 121d is connected to the MFCs 312, 322, 332, 512, and 522, the valves 314, 324, 334, 514, and 524, the pressure sensor 245, the APC valve 243, the vacuum pump 246, the heater 207, the temperature sensor 263, the rotator 267, the boat elevator 115, and the like.

The CPU 121a is configured to read and execute the control program from the memory 121c. The CPU 121a is further configured to read the recipe from the memory 121c according to an input of an operation command from the input/output device 122. The CPU 121a is configured to control the flow rate regulation operation of various kinds of gases by the MFCs 312, 322, 512, and 522, the opening/closing operation of the valves 314, 324, 514, and 524, the opening/closing operation of the APC valve 243, the pressure regulation operation performed by the APC valve 243 based on the pressure sensor 245, the temperature regulation operation performed by the heater 207 based on the temperature sensor 263, the actuating and stopping of the vacuum pump 246, the operation of rotating the boat 217 with the rotator 267 and adjusting a rotation speed of the boat 217, the operation of moving the boat 217 up or down by the boat elevator 115, the operation of accommodating the wafers 200 in the boat 217, and the like, according to contents of the read recipe.

The controller 121 may be constituted by installing, on the computer, the aforementioned program stored in an external memory (for example, a magnetic disk such as a magnetic tape, a flexible disk or a hard disk, an optical disc such as a CD or a DVD, a magneto-optical disc such as a MO, or a semiconductor memory such as a USB memory or a memory card) 123. The memory 121c and the external memory 123 are constituted as a computer-readable recording medium. Hereinafter, the memory 121c and the external memory 123 may be generally and simply referred to as a "recording medium." When the term "recording medium" is used herein, it may indicate a case of including the memory 121c, a case of including the external memory 123, or a case of including both the memory 121c and the external memory 123. The program may be provided to the computer by using a communication means or unit such as the Internet or a dedicated line, instead of using the external memory 123.

### (2) Substrate processing process

### (First Example of Process of Method of Processing Substrate)

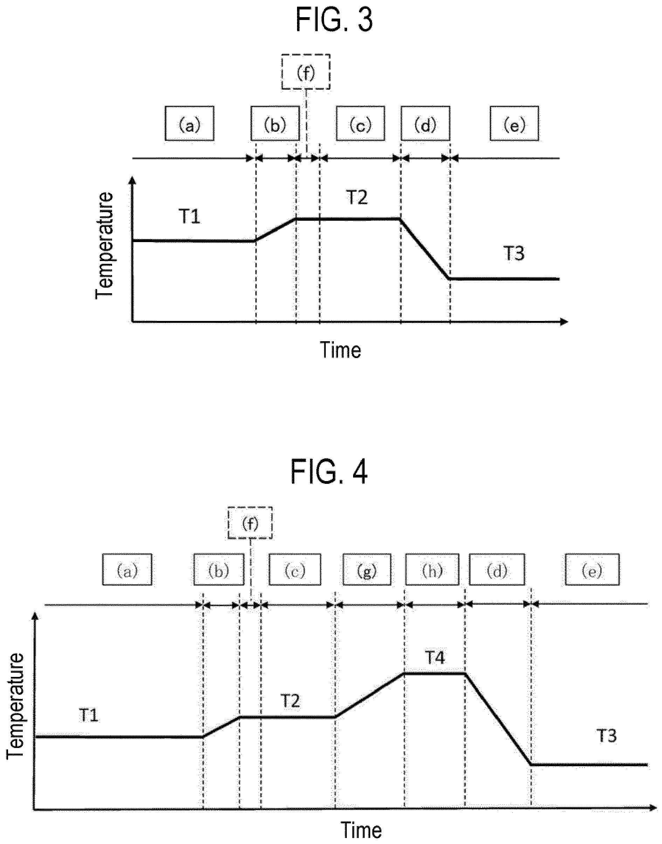

As a process of manufacturing a semiconductor device, an example of a process of a method of processing a substrate in which a metal film, that is, a Mo-containing film containing molybdenum (Mo), which is a transition metal element-containing film and a Group VI element-containing film, is formed on a wafer 200 in which a metal insulating film, that is, an aluminum oxide film (Al₂O₃ film, hereinafter also referred to as an AlO film) as a metal oxide film, is formed will be described with reference to FIG. 3. In FIG. 3, a vertical axis represents a temperature and a horizontal axis represents a time. The process of forming the Mo-containing film is performed by using the process furnace 202 of the above-described substrate processing apparatus 10. In the following description, the operation of each component of the substrate processing apparatus 10 is controlled by the controller 121.

A process of processing a substrate (process of manufacturing a semiconductor device) according to the embodiments of the present disclosure includes, for example,
(a) a step of loading a wafer (200) into a process chamber (201) in a process container at a loading temperature (T1) (loading step);
(b) a step of setting the process chamber (201) to a film formation temperature (T2) (first temperature regulating step);
(c) a step of forming a metal film on a surface of the wafer (200) by supplying a process gas into the process chamber (201) (film-forming step);
(d) a step of setting an interior of the process chamber (201) to an unloading temperature (T3) lower than the loading temperature (T1) (temperature-lowering step); and
(e) a step of unloading the wafer 200 from the process chamber 201 (unloading step);

When the term "wafer" is used in the present disclosure, it may refer to "a wafer itself" or "a stacked body of a wafer and certain layers or films formed on a surface of the wafer." When the phrase "a surface of a wafer" is used in the present disclosure, it may refer to "a surface of a wafer itself" or "a surface of a certain layer or film formed on a wafer." When the expression "a certain layer is formed on a wafer" is used in the present disclosure, it may mean that "a certain layer is formed directly on a surface of a wafer itself" or that "a certain layer is formed on a layer formed on a wafer." When the term "substrate" is used in the present disclosure, it may be synonymous with the term "wafer."

In the present disclosure, the processing temperature means a temperature of the wafer 200 or an internal temperature of the process chamber 201 (process container), and the processing pressure means an internal pressure of the process chamber 201. Further, the processing time means a time for which the processing is continued. These also apply to the following description.

### (a) Loading Step

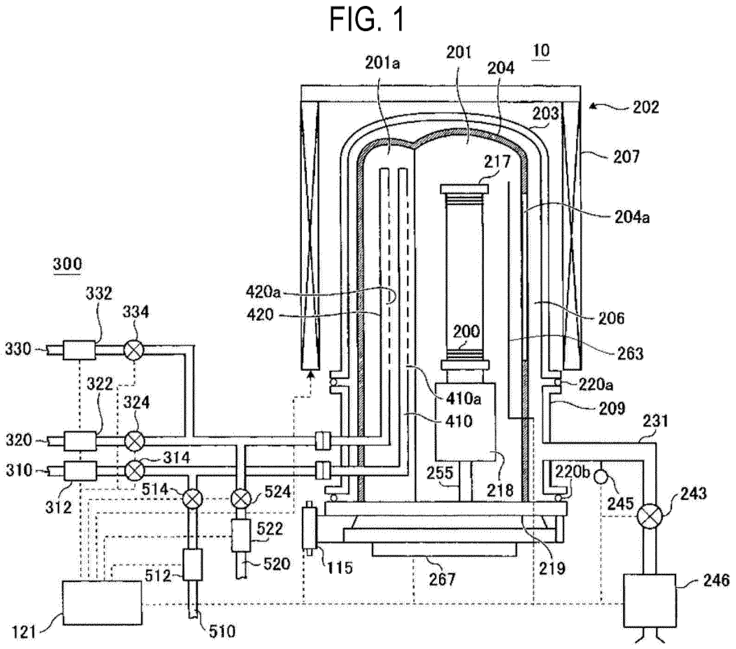

After the boat 217 is charged with a plurality of wafers 200 (wafer charging), as shown in FIG. 1, the boat 217 charged with the plurality of wafers 200 is lifted up by the boat elevator 115 to be loaded into the process chamber 201 (boat loading) and accommodated in process container. In such a state, the seal cap 219 closes the lower end opening of the outer tube 203 via the O-ring 220. At this time, the process chamber 201 is heated by the heater 207 so as to reach a loading temperature T1. The loading temperature T1 is set to, for example, 150 degrees C or higher and 500 degrees C or lower, specifically 200 degrees C or higher and 450 degrees C or lower, more specifically 300 degrees C or higher and 450 degrees C or lower.

### (b) First Temperature Regulating Step (First Temperature Regulating Step)

The interior of the process chamber 201 is heated by the heater 207 so as to reach a film formation temperature T2. At this time, a state of supplying electric power to the heater 207 is feedback-controlled based on the temperature information detected by the temperature sensor 263 such that a temperature distribution inside the process chamber 201 becomes a desired temperature distribution (temperature Regulation or temperature adjustment). The temperature of the heater 207 is regulated such that the internal temperature of the process chamber 201, that is, the temperature of the wafer 200, is raised from the loading temperature T1 to the film formation temperature T2, for example. The film formation temperature T2 is set to, for example, 300 degree C or higher and 600 degree C or lower, specifically 350 to 550 degree C, more specifically 400 to 500 degree C. The heating of the interior of the process chamber 201 by the heater 207 is continuously performed at least until the processing on the wafer 200 is completed.

At this time, at least one selected from the group of a hydrogen (H₂) gas, which is a hydrogen (H)-containing gas, and an inert gas may be supplied into the process chamber 201. For example, there may be a case where the H₂ gas is supplied, a case where the inert gas is supplied, and a case where both of the H₂ gas and the inert gas are supplied. An example of using an argon (Ar) gas as the inert gas is described below. In this example, the H₂ gas is supplied into the process chamber 201 mainly via the gas supply pipe 320, the MFC 322, the valve 324, and the nozzle 420. Further, the Ar gas is supplied into the process chamber 201 mainly via the gas supply pipe 520, the MFC 522, the valve 524, and the nozzle 420.

Herein, the H₂ gas may be regarded as a reducing gas. That is, in at least a portion of the first temperature regulating step, a reducing gas is supplied into the process container. As a result, it is possible to regulate the temperature while reducing the surface of the wafer 200, such that an impurity concentration in a metal film formed on the wafer 200 may decrease. Herein, the impurity in the film means an element that is not contained in a chemical composition of a target film. When the film is a film composed of a metal element, elements other than the metal element may be impurities. Specifically, in the case of a Mo film, elements other than Mo, such as at least one selected from the group of H, chlorine (Cl), and oxygen (O), are impurities.

Further, the H₂ gas may be regarded as a high-thermal conductive gas. That is, in at least a portion of the first temperature regulating step, the high-thermal conductive gas is supplied into the process container. When the high-thermal conductive gas is supplied into the process chamber 201, an amount of heat conducted per unit time from the heater 207 to a gas within the process chamber 201 increases. Further, when the high-thermal conductive gas is supplied into the process chamber 201, an amount of heat conducted per unit time from the gas in the process chamber 201 to the wafer 200 increases. For these reasons, the temperature of the gas in the process chamber 201 and the temperature of the wafer 200 rise in a shorter time than when the high-thermal conductive gas is not supplied into the process chamber 201. That is, a time for temperature regulation in the process chamber 201 is shortened.

Further, the H₂ gas may be regarded as a reductive high-thermal conductive gas. That is, in at least a portion of the first temperature regulating step, a reductive high-thermal conductive gas is supplied into the process container. As a result, it is possible to regulate the internal temperature of the process chamber 201 in a short time while reducing the surface of the wafer 200.

Further, a flow rate of the reducing gas (H₂ gas) may be gradually increased in at least a portion of the first temperature regulating step, for example, in the latter half of the first temperature regulating step. By increasing the concentration of the reducing gas in the process chamber 201, it is possible to regulate the internal temperature of the process chamber 201 in a short time while further promoting the reduction reaction. Further, a flow rate of the high-thermal conductive gas may be gradually increased in at least a portion of the first temperature regulating step, for example, in the latter half of the first temperature regulating step. As a result, the internal temperature of the process chamber 201 and the temperature of the wafer 200 may be prevented from abruptly changing. Therefore, since a thermal stress on the surface of the wafer 200 is decreased, pattern collapse of the wafer 200 may be suppressed.

Further, in a case where the H₂ gas is supplied into the process chamber 201 to perform the first temperature regulating step, when the internal pressure of the process chamber 201 is lower than 4,000 Pa, it may be difficult to obtain an effect of shortening the time for temperature regulation, and when the internal pressure of the process chamber 201 is equal to or higher than 4,000 Pa, it is possible to sufficiently shorten the time for temperature regulation. Further, when the internal pressure of the process chamber 201 is equal to or higher than 6,000 Pa, it is possible to further shorten the time for temperature regulation. Further, when the internal pressure of the process chamber 201 is higher than 13,000 Pa, the wafer 200 may be etched by by-products generated due to the reduction of the wafer 200 by the H₂ gas, and when the internal pressure of the process chamber 201 is equal to or lower than 13,000 Pa, it is possible to suppress the etching by the by-products. Further, when the internal pressure of the process chamber 201 is equal to or lower than 11,000 Pa, it is possible to sufficiently suppress the etching by the by-products. Therefore, the internal pressure of the process chamber 201 is specifically 4,000 Pa or more and 13,000 Pa or less, more specifically 6,000 Pa or more and 11,000 Pa or less.

When the H₂ gas is supplied in the first temperature regulating step, the substrate is reduced while the temperature being raised. Therefore, depending on the substrate, an unintended reduction reaction may cause a difference in an amount of reduction for each substrate. To suppress such a difference in the amount of reduction, in the first temperature regulating step, an inert gas may be supplied, a non-reductive high-thermal conductive gas may be supplied, or both of them may be supplied.

Further, the interior of the process chamber 201, that is, a space where the wafer 200 is placed, is vacuum-exhausted by the vacuum pump 246 to reach a desired pressure (state of vacuum). At this time, the internal pressure of the process chamber 201 is measured by the pressure sensor 245, and the APC valve 243 is feedback-controlled based on the measured pressure information (pressure regulation). The vacuum pump 246 constantly keeps in operation at least until processing on the wafer 200 is completed.

### (f) Film Formation Preparing Step

Next, a step of supplying a high-thermal conductive gas into the process chamber 201 (film formation preparing step) may be performed. That is, the high-thermal conductive gas may be supplied into the process container. For example, a H₂ gas may be used as the high-thermal conductive gas. The film formation preparing step may be performed when a gas other than the high-thermal conductive gas is supplied in the first temperature regulating step.

Herein, a case where in the first temperature regulating step, after supplying a gas, for example, an Ar gas that is not a high-thermal conductive gas, in a film-forming step described below, a reductive high-thermal conductive gas (for example, a H₂ gas) as a reducing gas is supplied to the wafer 200 is considered. In such a case, the substrate temperature of the wafer 200 may change abruptly due to a difference in thermal conductivity between gases supplied into the process chamber 201 in the first temperature regulating step and the film-forming step. As a result, a thermal stress is generated on the surface of the wafer 200, and a pattern formed on the surface of the wafer 200 may be damaged (pattern collapse may occur). By performing the film formation preparing step, it is possible to decrease the difference in thermal conductivity between the gases supplied into the process chamber 201 in the first temperature regulating step and the film-forming step. Therefore, it is possible to decrease the thermal stress on the surface of the wafer 200 as described above, thereby suppressing the pattern collapse.

Further, in at least a portion of the film formation preparing step, a supply amount of the high-thermal conductive gas may be increased. As a result, since an abrupt temperature change of the wafer 200 may be suppressed to decrease the thermal stress, the pattern collapse of the wafer 200 may be suppressed.

### (c) Film-Forming Step

In a film-forming step, a process gas is supplied into the process chamber 201 to form a metal film on the surface of the wafer 200. In this operation, the interior of the process chamber 201 is heated by the heater 207 so as to reach the film formation temperature T2. The film formation temperature T2 is set to a temperature higher than the loading temperature T1 (T1<T2). The film formation temperature T2 is, for example, set to a temperature within a range of 300 degrees C or higher and 600 degrees C or lower, specifically 350 degrees C or higher and 550 degrees C or lower, more specifically 400 degrees C or higher and 500 degrees C or lower.

The film-forming step includes (c1) a metal-containing gas supplying step, (c2) a residual gas removing step, (c3) a reducing gas supplying step, (c4) a residual gas removing step, and (c5) a step of performing a predetermined number of times, which are described below.

### (c1) Metal-containing Gas Supplying Step

The valve 314 is opened to allow a metal-containing gas, which is a precursor gas as a process gas, to flow through the gas supply pipe 310. An example in which a Mo-containing gas is used as the metal-containing gas is described below. A flow rate of the Mo-containing gas is regulated by the MFC 312, and the Mo-containing gas is supplied into the process chamber 201 via the gas supply hole 410a of the nozzle 410 and is exhausted via the exhaust pipe 231. In this operation, the Mo-containing gas is supplied to the wafer 200. At the same time, the valve 514 is opened to flow an Ar gas through the gas supply pipe 510. A flow rate of the Ar gas flowing through the gas supply pipe 510 is regulated by the MFC 512, and the Ar gas is supplied into the process chamber 201 together with the Mo-containing gas and is exhausted via the exhaust pipe 231. Further, at this time, the valve 524 is opened to allow an Ar gas to flow through the gas supply pipe 520 so as to prevent the Mo-containing gas from entering the nozzle 420. The Ar gas is supplied into the process chamber 201 via the gas supply pipe 320 and the nozzle 420 and is exhausted via the exhaust pipe 231.

At this time, the APC valve 243 may be regulated to set the internal pressure of the process chamber 201 to a pressure within a range of, for example, 4,000 Pa to 11,000 Pa. A supply flow rate of the metal-containing gas controlled by the MFC 312 is set to fall within a range of, for example, 0.1 to 1.0 slm, specifically 0.3 to 0.9 slm. Supply flow rates of the Ar gases controlled by the MFCs 512 and 522 are respectively set to fall within a range of, for example, 0.1 to 20 slm.

By supplying the Mo-containing gas, a Mo-containing layer is formed as a metal-containing layer on the wafer 200 (an AlO film as a base film on the surface of the wafer 200). The Mo-containing layer may be a Mo layer containing Cl, O, or H, or an adsorption layer for the Mo-containing gas, or may include both of the Mo layer and the adsorption layer for the Mo-containing gas.

### (c2) Residual Gas Removing Step

After a predetermined time elapses from the start of the supply of the Mo-containing gas, for example, after 0.01 to 60 seconds, the valve 314 of the gas supply pipe 310 is closed to stop the supply of the Mo-containing gas. That is, a time for the supply of the Mo-containing gas to the wafer 200 is set to fall within a range of, for example, 0.01 to 60 seconds. At this time, with the APC valve 243 of the exhaust pipe 231 left open, the interior of the process chamber 201 is vacuum-exhausted by the vacuum pump 246. That is, the interior of the process chamber 201 is purged. At this time, the valves 514 and 524 are left open to maintain the supply of the Ar gas into the process chamber 201. The Ar gas acts as a purge gas, which may enhance an effect of excluding an unreacted Mo-containing gas or a Mo-containing gas that contributed to the formation of the metal-containing layer, which remains in the process chamber 201, from the process chamber 201.

### (c3) Reducing Gas Supplying Step

After removing the residual gas in the process chamber 201, the valve 324 is opened to allow a H₂ gas, which is a reducing gas as a process gas, to be supplied into the gas supply pipe 320. A flow rate of the H₂ gas is regulated by the MFC 322, and the H₂ gas is supplied into the process chamber 201 via the gas supply hole 420a of the nozzle 420 and is exhausted via the exhaust pipe 231. In this operation, the H₂ gas is supplied to the wafer 200. At the same time, the valve 524 is opened to allow an Ar gas to flow through the gas supply pipe 520. A flow rate of the Ar gas flowing through the gas supply pipe 520 is regulated by the MFC 522. The Ar gas is supplied into the process chamber 201 together with the H₂ gas and is exhausted via the exhaust pipe 231. At this time, the valve 514 is opened to allow an Ar gas to flow through the gas supply pipe 510 to prevent the H₂ gas from entering the nozzle 410. The Ar gas is supplied into the process chamber 201 via the gas supply pipe 310 and the nozzle 410 and is exhausted via the exhaust pipe 231.

At this time, the APC valve 243 is regulated to set the internal pressure of the process chamber 201 to fall within a range of, for example, 4,000 Pa to 13,000 Pa. A supply flow rate of the H₂ gas controlled by the MFC 322 is set to fall with a range of, for example, 1 to 60 slm, specifically 15 to 35 slm. Supply flow rates of the Ar gases controlled by the MFCs 512 and 522 are respectively set to fall within a range of, for example, 0.1 to 30 slm. A time for the supply of the H₂ gas to the wafer 200 is set to fall within a range of, for example, 0.01 to 600 seconds.

At this time, the gases flowing into the process chamber 201 are the H₂ gas and the Ar gas. Herein, the H₂ gas undergoes a substitution reaction with at least a portion of the Mo-containing layer formed on the wafer 200 in the metal-containing gas supplying step. That is, O or chlorine in the Mo-containing layer react with the H₂ gas to be desorbed from the Mo layer and is discharged from the process chamber 201, as reaction by-products such as water vapor (H₂O), hydrogen chloride (HCl), or chlorine (Cl₂). That is, since the film formation may be performed while reducing the surface of the wafer 200 and the formed film with the H₂ gas, an impurity concentration in the metal film may be decreased.

Further, in a case where the H₂ gas is supplied into the process chamber 201 to perform the film-forming step, when the internal pressure of the process chamber 201 is lower than 4,000 Pa, it may be difficult to obtain an effect of reducing the impurity concentration due to the reduction of the wafer 200 and the metal film by the H₂ gas, and when the internal pressure of the process chamber 201 is equal to or higher than 4,000 Pa, it is possible to obtain the effect due to the reduction. When the internal pressure of the process chamber 201 is equal to or higher than 6,000Pa, it is possible to sufficiently obtain the effect due to the reduction. Further, when the internal pressure of the process chamber 201 is higher than 13,000 Pa, the wafer 200 may be etched by by-products generated due the reduction of the wafer 200 by the H₂ gas, and when the internal pressure of the process chamber 201 is equal to or lower than 13,000 Pa, it is possible to suppress the etching by the by-products. Further, when the internal pressure of the process chamber 201 is equal to or lower than 11,000 Pa, it is possible to sufficiently suppress the etching by the by-products. Therefore, the internal pressure of the process chamber 201 is specifically 4,000 Pa or more and 13,000 Pa or less, more specifically 6,000 Pa or more and 11,000 Pa or less.

### (c4) Residual Gas Removing Step

After forming the metal layer, the valve 324 is closed to stop the supply of the H₂ gas. Then, the H₂ gas remaining in the process chamber 201, which is unreacted or contributed to the formation of the metal layer, and reaction by-products are removed from the process chamber 201 according to a processing procedure which is the same as that in the above-described step (c2: residual gas removing step). That is, the interior of the process chamber 201 is purged.

### (c5) Step of Performing Predetermined Number of Times

By performing a cycle a predetermined number of times (n times, where n is an integer of 1 or more), the cycle including sequentially performing the above-described steps c1 to c4, a metal-containing film with a predetermined thickness (for example, 0.5 to 40.0 nm) is formed on the wafer 200. The above-described cycle may be performed multiple times. Further, each of the steps c1 to c4 may be performed at least one or more times. That is, a cycle including non-simultaneously performing: supplying the metal-containing gas into the process container; and supplying the hydrogen-containing gas into the process container is performed a predetermined number of times.

### (d) Temperature-Lowering Step

After the film-forming step, a temperature-lowering step is performed. In the temperature-lowering step, the heating of the heater 207 is controlled such that the temperature of the process chamber 201 changes from the film formation temperature T2 to the unloading temperature T3. The unloading temperature T3 is set to be lower than the loading temperature T1 (T3<T1). For example, the unloading temperature T3 is set to a temperature within a range of 400 degrees C or less, specifically 250 degrees C or less, more specifically 100 degrees C or less. The interior of the process chamber 201, that is, a space where the wafer 200 is placed is vacuum-exhausted by the vacuum pump 246 to reach a desired pressure (state of vacuum).

At this time, a H₂ gas is supplied as a reducing gas to the process chamber 201. That is, a reducing gas is supplied into the process chamber 201 in at least a portion of the temperature-lowering step. As a result, it is possible to lower the internal temperature of the process chamber 201 while reducing the metal film, such that the impurity concentration in the metal film decreases, thereby improving electrical characteristics of the metal film. Herein, the impurity in the temperature-lowering step may mean, for example, nitrogen (N), in addition to the above-described impurity.

Further, the H₂ gas may be regarded as a high-thermal conductive gas. That is, in at least a portion of the temperature-lowering step, the high-thermal conductive gas is supplied into the process chamber 201. This shortens a temperature-lowering time. Further, since a difference between an actual temperature of the wafer 200 and an in-furnace temperature of the process container is smaller than that when the temperature is lowered in an atmosphere other than a high-thermal conductive gas atmosphere, controllability of the substrate temperature of the wafer 200 is improved.

In a case where the H₂ gas is supplied into the process chamber 201 to perform the temperature-lowering step, when the internal pressure of the process chamber 201 is lower than 4,000 Pa, it may be difficult to obtain the effect of shortening the time for temperature regulation, and when the internal pressure of the process chamber 201 is equal to or higher than 4,000Pa, it is possible to shorten the time for temperature regulation. Further, when the internal pressure of the process chamber 201 is equal to or higher than 6,000 Pa, it is possible to sufficiently shorten the time for temperature regulation. Further, when the internal pressure of the process chamber 201 is higher than 13,000 Pa, the wafer 200 may be etched by by-products generated due to the reduction of the wafer 200 by the H₂ gas, and when the internal pressure of the process chamber 201 is equal to or lower than 13,000 Pa, it is possible to suppress the etching by the by-products. Further, when the internal pressure of the process chamber 201 is equal to or lower than 11,000 Pa, it is possible to sufficiently suppress the etching by the by-products. Therefore, when the H₂ gas is supplied into the process chamber 201 to perform the temperature-lowering step, the internal pressure of the process chamber 201 is specifically 4,000Pa or more and 13,000 Pa or less, more specifically 6,000 Pa or more and 11,000 Pa or less.

Further, the H₂ gas may be regarded as a reductive high-thermal conductive gas. That is, in at least a portion of the temperature-lowering step, a reductive high-thermal conductive gas is supplied into the process chamber 201. This may shorten the temperature-lowering time while reducing the metal film.

Further, the internal temperature of the process chamber 201 may be lowered while maintaining a state in which the interior of the process chamber 201 is vacuum-exhausted. That is, in at least a portion of the temperature-lowering step, the process chamber 201 may be kept in a vacuum state. Specifically, while maintaining the interior of the process chamber 201 at 1 Pa to 100 Pa, the internal temperature of the process chamber 201 may be lowered to 250 degrees C or lower, specifically 100 degrees C or lower. In such a case, since heat conduction between the wafer 200 and the surrounding gas is difficult to occur, a temperature-lowering rate of the wafer 200 and the metal film decreases. As a result, since a time for which the temperature of the wafer 200 is high becomes longer, the wafer 200 is subjected to heat treatment. This heat treatment results in improvement of crystallinity of the metal film. Further, since the impurities in the metal film are easily desorbed due to a low pressure around the wafer 200, the impurity concentration in the metal film decreases. According to the above-described configurations, the electrical characteristics of the metal film may be improved. When the internal pressure of the process chamber 201 is higher than 100 Pa, it may be difficult to obtain the above-described effects, due to at least one selected from the group of a feature that heat conduction between the wafer 200 and the surrounding gas may be easily generated and a feature that it is difficult to desorb impurities from the metal film.

### (e) Unloading Step

After the temperature-lowering step, an unloading step is performed. An Ar gas is supplied into the process chamber 201 from each of the gas supply pipes 510 and 520, the internal atmosphere of the process chamber 201 is substituted with the Ar gas (inert gas substitution), and the internal pressure of the process chamber 201 is returned to the atmospheric pressure (returning to atmospheric pressure). The seal cap 219 is moved down by the boat elevator 115 to open the lower end of the outer tube 203. Then, the wafer 200 supported by the boat 217 is unloaded from the lower end of the outer tube 203 to the outside of the outer tube 203 (boat unloading). Thereafter, the processed wafer 200 is discharged from the boat 217 (wafer discharging).

As described above, in the process of processing the substrate according to the present disclosure, the step of unloading the wafer 200 from the process chamber 201 (the unloading step) is performed after the step of setting the interior of the process chamber 201 to the unloading temperature T3 lower than the loading temperature T1(T3<T1) (the temperature-lowering step). That is, after the metal film is formed, the wafer 200 is cooled to the unloading temperature T3, which is lower than the loading temperature T1, and then is unloaded to the outside of the outer tube 203. As a result, since the temperature of the wafer 200 at the time of unloading is lowered, alteration of the metal film at the time of unloading is suppressed. Therefore, the electrical characteristics of the metal film are improved. Herein, the alteration of the metal film that occurs during the unloading step means that, for example, at least one selected from the group of nitridation and oxidation occurs in the metal film due to the internal atmosphere or the external atmosphere of the process chamber 201.

### (Second Example of Process of Method of Processing Substrate)

FIG. 4 is a flow diagram for explaining a method for manufacturing a semiconductor device according to a second example of the process of the method of processing the substrate. FIG. 4 shows an example of a process of forming a Mo-containing film on the wafer 200, similarly to FIG. 3, where a vertical axis represents a temperature and a horizontal axis represents a time. In the description of FIG. 4, parts different from the manufacturing process of FIG. 3 will be mainly described, components that are substantially the same as those described with reference to FIG. 3 are denoted by the same reference numerals, and explanation thereof will not be repeated.

A main difference between FIG. 4 and FIG. 3 is that a second temperature regulating step and a holding step are added between the film-forming step and the temperature-lowering step. The second temperature regulating step and the holding step will be described below.

### (g) Second Temperature Regulating Step (Second Temperature Adjusting Step)

After the film-forming step, a second temperature regulating step is performed. In the second temperature regulating step, the internal temperature of the process chamber 201 or the temperature of the wafer 200 is raised from the film formation temperature T2 to a holding temperature T4 higher than the film formation temperature T2 (T4>T2). In the second temperature regulating step, the internal temperature of the process chamber 201 or the temperature of the wafer 200 is raised from the film formation temperature T2 to the holding temperature T4. Herein, the heating of the heater 207 is controlled such that the internal temperature of the process chamber 201 is raised from the film formation temperature T2 to the holding temperature T4.

In the second temperature regulating step, for example, the interior of the process chamber 201, that is, the space where the wafer 200 is placed, is vacuum-exhausted by the vacuum pump 246 to reach a desired pressure (state of vacuum).

At this time, a H₂ gas is supplied from the gas supply pipe 320 into the process chamber 201 via the MFC 322, the valve 324, and the nozzle 420. Further, an Ar gas is supplied as an inert gas from the gas supply pipe 520 into the process chamber 201 via the MFC 522, the valve 524, and the nozzle 420.

Herein, the H₂ gas may be regarded as a reducing gas. That is, in at least a portion of the second temperature regulating step, the reducing gas is supplied into the process chamber 201. As a result, since it is possible to regulate the temperature while reducing the metal film, the impurity concentration in the metal film may decrease. Therefore, the electrical characteristics of the metal film are improved. Further, the H₂ gas may be regarded as a high-thermal conductive gas. That is, in at least a portion of the second temperature regulating step, the high-thermal conductive gas is supplied into the process chamber 201. As a result, the time for temperature regulation may be shortened. Further, the H₂ gas may be regarded as a reductive high-thermal conductive gas. That is, in at least a portion of the second temperature regulating step, the reductive high-thermal conductive gas is supplied into the process container. As a result, it is possible to regulate the internal temperature of the process chamber 201 in a short time while reducing the surface of the wafer 200 with the H₂ gas.

Herein, in the film-forming step, a case is considered in which a reductive high-thermal conductive gas (for example, a H₂ gas) as a reducing gas is supplied into the process chamber 201. When a high-thermal conductive gas is supplied into the process chamber 201 at the start of the second temperature regulating step, since a difference in thermal conductivity between gases supplied in the film-forming step and the second temperature regulating step is small, a temperature change of the wafer 200 decreases. As a result, a thermal stress on the surface of the wafer 200 may be decreased, thereby suppressing the pattern collapse.

Further, In a case where the H₂ gas is supplied into the process chamber 201 to perform the second temperature regulating step, when the internal pressure of the process chamber 201 is lower than 4,000 Pa, it may be difficult to obtain the effect of shorten the time for temperature regulation, and when the internal pressure of the process chamber 201 is equal to or higher than 4,000 Pa, it is possible to obtain the effect of shortening the time for temperature regulation. Further, when the internal pressure of the process chamber 201 is equal to or higher than 6,000Pa, it is possible to sufficiently obtain the effect of shortening the time for temperature regulation. Further, when the internal pressure of the process chamber 201 is higher than 13,000 Pa, the wafer 200 may be etched by by-products generated due the reduction of the wafer 200 by the H₂ gas, and when the internal pressure of the process chamber 201 is equal to or lower than 13,000 Pa, it is possible to suppress the etching by the by-products. Further, when the internal pressure of the process chamber 201 is equal to or lower than 11,000 Pa, it is possible to sufficiently suppress the etching by the by-products. Therefore, the internal pressure of the process chamber 201 is specifically 4,000 Pa or more and 13,000 Pa or less, more specifically 6,000 Pa or more and 11,000 Pa or less.

Further, the interior of the process chamber 201 may be set to the holding temperature while maintaining the state in which the interior of the process chamber 201 is vacuum-exhausted. In such a case, since the impurities in the metal film are easily desorbed due to a low pressure around the wafer 200, the impurity concentration in the metal film decreases.

### (h) Holding Step (Annealing Step, Heat Treatment Step)

A holding step is performed after the second temperature regulating step. In the holding step, the wafer 200 on which the metal film is formed in the film-forming step is held in the process chamber 201 at the holding temperature T4 higher than the film formation temperature T3 (T4>T3). That is, the wafer 200 is annealed (heat-treated) at the holding temperature T4. As a result, a diameter (grain size) of a crystal grain constituting the metal film increases, thereby improving the electrical characteristics of the metal film. The holding temperature T4 is set to a temperature within a range of, for example, 500 degrees C or higher and 650 degrees C or lower, specifically 550 degrees C or higher and 600 degrees C or lower.

At this time, a H₂ gas is supplied as a reducing gas from the gas supply pipe 320 into the process chamber 201 via the MFC 322, the valve 324, and the nozzle 420. Further, an Ar gas is supplied as an inert gas from the gas supply pipe 520 into the process chamber 201 via the MFC 522, the valve 524, and the nozzle 420. That is, in at least a portion of the holding step, the reducing gas is supplied into the process chamber 201. Since it is possible to perform the heat treatment while reducing the metal film, the impurity concentration in the metal film may decrease, thereby improving the electrical characteristics of the metal film.

Further, in a case where the H₂ gas is supplied into the process chamber 201 to perform the holding step, when the internal pressure of the process chamber 201 is lower than 4,000 Pa, it may be difficult to obtain the effect of decreasing the impurity concentration by reducing the wafer 200 and the metal film, and when the internal pressure of the process chamber 201 is equal to or higher than 4,000 Pa, it is possible to obtain the effect due to the reduction. When the internal pressure of the process chamber 201 is equal to or higher than 6,000 Pa, it is possible to sufficiently obtain the effect of shortening the time for temperature regulation. Further, when the internal pressure of the process chamber 201 is higher than 13,000 Pa, the wafer 200 may be etched by by-products generated due to the reduction of the wafer 200 by the H₂ gas, and when the internal pressure of the process chamber 201 is equal to or lower than 13,000 Pa, it is possible to suppress the etching by the by-products. Further, when the internal pressure of the process chamber 201 is equal to or lower than 11,000 Pa, it is possible to sufficiently suppress the etching by the by-products. Therefore, the internal pressure of the process chamber 201 is specifically 4,000 Pa or more and 13,000 Pa or less, more specifically 6,000 Pa or more and 11,000 Pa or less.

According to the second example, the effects similar to those of the first example may be obtained, in addition to the above-described effects of the second temperature regulating step and the holding step.

The gases will be described below.

As the inert gas, a gas that hardly reacts with the metal film formed in the substrate processing process may be used. For example, the inert gas may be appropriately selected among rare gases such as a helium (He) gas, a neon (Ne), an argon (Ar) gas, and a xenon (Xe) gas, and a nitrogen (N₂) gas. Depending on a film to be formed, the N₂ gas may alter the film. In such a case, a gas other than the N₂ gas is used. For example, when forming a Mo film as the metal film, it may be possible to use an inert gas other than the N₂ gas because the Mo film may be altered by the N₂ gas.

Examples of the reducing gas may include a H₂ gas, a deuterium (D₂) gas, a borane (BH₃) gas, a diborane (B₂H₆) gas, a carbon monoxide (CO) gas, an ammonia (NH₃) gas, a monosilane (SiH₄) gas, a disilane (Si₂H₆) gas, a trisilane (Si₃H₈) gas, a monogermane (GeH₄) gas, and a digermane (Ge₂H₆) gas.

The high-thermal conductive gas in the present disclosure is a gas whose thermal conductivity is higher than that of a gas used as the inert gas. Herein, the thermal conductivity of the gas is higher as molecular weight of molecules (gas molecules) that mainly constitute the gas is smaller. Therefore, for example, when an Ar gas is used as the inert gas, a H₂ gas, a D₂ gas, a He gas, a BH₃ gas, a B₂H₆ gas, a NH₃ gas, a N₂ gas, a Ne gas, a SiH₄ gas, and a CO gas, which are gases whose molecular weight is smaller than that of Ar, may be used as the high-thermal conductive gas. Further, for example, when a N₂ gas is used as the inert gas, a H₂ gas, a D₂ gas, a He gas, a BH₃ gas, and a Ne gas, which are gases whose molecular weight is smaller than that of N₂, may be used as the high-thermal conductive gas. Further, for example, when a He gas is used as the inert gas, a H₂ gas and a D₂ gas, which are gases whose molecular weight is smaller than that of He, may be used as the high-thermal conductive gas.

A reductive high-thermal conductive gas in the present disclosure is a gas that belongs to both the above-described reducing gas and high-thermal conductive gas. Therefore, for example, when an Ar gas is used as the inert gas, a H₂ gas, a D₂ gas, a BH₃ gas, a B₂H₆ gas, a NH₃ gas, a SiH₄ gas, and a CO gas may be used as the reductive high-thermal conductive gas. Specifically, a H₂ gas or a D₂ gas may be used as the reductive high-thermal conductive gas.

Since D₂ is more active than H₂, the D₂ gas is greater in an effect of reducing action than the H₂ gas. Therefore, when the D₂ gas is used as the reducing gas, the impurity concentration in the metal film may be decreased more than when the H₂ gas is used.

In a case where a H₂ gas as the reducing gas, the high-thermal conductive gas, or the reductive high-thermal conductive gas is supplied into the process chamber 201, as a mixed gas of H₂ and another gas, when a mass fraction of H₂ in the mixed gas is less than 70%, the reducing action may not be sufficiently obtained, and an electrical resistance of the metal film may not reach a target value. By setting the mass fraction of H₂ in the mixed gas to 70% or more, the reduction action may be sufficiently obtained, and the electrical resistance of the metal film may reach the target value. Further, by setting the mass fraction of H₂ in the mixed gas to 90% or more, the electric resistance of the metal film may be improved over the target value. In other words, it is possible to obtain a metal film with the electrical characteristics exceeding the target value. For this reason, the mass fraction of H₂ in the mixed gas is specifically 70% or more, more specifically 90% or more. Further, since the mixed gas contains hydrogen, the mixed gas may be called a hydrogen-containing gas.

Herein, at least a portion of the gas molecules in the process chamber 201 may be radicalized or excited by a plasma generator (not shown in FIG. 1). The impurities in the metal film may be removed by using the gas activated by plasma in this way.

The metal film in the present disclosure is a film containing a metal element as a main element. The metal element may be a transition metal element. Examples of the transition metal element may include Group IV elements such as zirconium (Zr), hafnium (Hf), and titanium (Ti), Group VI elements such as Mo and tungsten (W), Group VIII elements such as ruthenium (Ru), and Group V elements such as vanadium (V), niobium (Nb), and tantalum (Ta). Further, in addition to the transition metal, elements such as aluminum (Al), gallium (Ga), an indium (In), which are Group XIII elements, may be used as the metal element.

As the metal-containing gas, for example, a gas containing the above-mentioned metal element may be used. As the metal-containing gas, for example, a halogen-based metal-containing gas containing the above-mentioned metal element and a halogen element (for example, fluorine (F), Cl, bromine (Br), or iodine (I)) may be used. As the halogen-based metal-containing gas, for example, a halogen-based transition metal-containing gas containing a transition metal element may be used. As the halogen-based transition metal-containing gas, for example, a halogen element- and Mo-containing gas containing Mo may be used. As the halogen element- and Mo-containing gas, for example, a molybdenum dichloride dioxide (MoO₂Cl₂) gas, a molybdenum oxide tetrachloride (MoOCl₄) gas, a molybdenum pentachloride (MoCls), and the like may be used. Since it is difficult for halogen elements to remain as impurities in metal films, by forming a metal film with a metal-containing gas containing a halogen element, it is possible to suppress deterioration of electrical characteristics (for example, electrical resistance) of the metal film. Further, when an O-free and metal-containing gas (Mo-containing gas) such as a MoCl₅ gas is used, oxidation of the wafer 200 and the metal film may be suppressed, thereby suppressing the deterioration of the electrical characteristics of the metal film.

Examples in which a film is formed by using a batch-type substrate processing apparatus capable of processing a plurality of substrates at a time are described in the above-described embodiments of the present disclosure. The present disclosure is not limited to the above-described embodiments, but may be suitably applied, for example, to a case where a film is formed by using a single-wafer-type substrate processing apparatus capable of processing a single substrate or several substrates at a time. In addition, examples in which a film is formed by using a substrate processing apparatus including a hot-wall-type process furnace are described in the above-described embodiments. The present disclosure is not limited to the above-described embodiments, but may be suitably applied to a case where a film is formed by using a substrate processing apparatus including a cold-wall-type process furnace. Even when these substrate processing apparatuses are used, the respective processes may be performed according to the same processing procedures and process conditions as those of the above-described embodiments and modifications, and the same effects as those of the above-described embodiments and modifications may be obtained.

As described above, the disclosure made by the present disclosers is specifically described above based on the embodiments, but it goes without saying that the present disclosure is not limited to the above-described embodiments and may be modified in various ways. Moreover, the above-described embodiments and modifications may be used in proper combination. Processing procedures and process conditions used in such cases may be the same as, for example, the processing procedures and process conditions in the above-described embodiments and modifications.

According to the present disclosure in some embodiments, it is possible to provide a technique capable of improving electrical characteristics of a metal film.

While certain embodiments are described above, these embodiments are presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A method of processing a substrate, comprising:
(a) loading the substrate into a process container at a loading temperature;
(b) setting an interior of the process container to a film formation temperature;
(c) forming a metal film on a surface of the substrate by supplying a process gas into the process container;
(d) setting the interior of the process container to an unloading temperature lower than the loading temperature; and
(e) unloading the substrate from the process container.

2. The method of Claim 1, wherein the process gas includes a metal-containing gas and a reducing gas, and
wherein in (c), a cycle is performed a predetermined number of times, the cycle including:
supplying the metal-containing gas into the process container; and
supplying the reducing gas into the process container.

3. The method of Claim 1, wherein in at least a portion of (b), one of a reducing gas, a high-thermal conductive gas, and a reductive high-thermal conductive gas is supplied into the process container.

4. The method of Claim 3, wherein in at least a portion of (b), a supply amount of one of the reducing gas, the high-thermal conductive gas, and the reductive high-thermal conductive gas into the process container is increased.

5. The method of Claim 2, wherein the reducing gas that is supplied in (c) is a reductive high-thermal conductive gas, and
wherein the method further comprises (f) supplying a high-thermal conductive gas into the process container before (c).

6. The method of Claim 5, wherein in at least a portion of (f), a supply amount of the high-thermal conductive gas is increased.

7. The method of Claim 1, wherein in at least a portion of (d), the interior of the process container is kept in a vacuum state, and an internal temperature of the process container is changed.

8. The method of Claim 1, wherein in at least a portion of (d), at least one selected from the group of a reducing gas, a high-thermal conductive gas, and a reductive high-thermal conductive gas is supplied into the process container.

9. The method of Claim 1, further comprising: before (d),
(g) setting the interior of the process container to a holding temperature; and
(h) keeping the interior of the process container at the holding temperature.

10. The method of Claim 9, wherein in at least a portion of (g), the interior of the process container is kept in a vacuum state, and an internal temperature of the process container is lowered to the unloading temperature.

11. The method of Claim 9, wherein in at least a portion of (g), at least one selected from the group of a reducing gas, a high-thermal conductive gas, and a reductive high-thermal conductive gas is supplied into the process container.

12. The method of Claim 9, wherein in at least a portion of (h), a reducing gas is supplied into the process container.

13. A method of manufacturing a semiconductor device, comprising the method of Claim 1.

14. A substrate processing apparatus comprising:
a process container whose interior is controlled to be set to a loading temperature, a film formation temperature, and an unloading temperature lower than the loading temperature and in which a substrate is processed;
a loading and unloading equipment configured to load the substrate into the process container and unload the substrate from the process container; and
a process gas supply system configured to form a metal film on a surface of the substrate by supplying a process gas into the process container.

15. A program that causes, by a computer, a substrate processing apparatus to perform a method comprising:
(a) loading a substrate into a process container at a loading temperature;
(b) setting an interior of the process container to a film formation temperature;
(c) forming a metal film on a surface of the substrate by supplying a process gas into the process container;
(d) setting the interior of the process container to an unloading temperature lower than the loading temperature; and
(e) unloading the substrate from the process container.
